# EUROPEAN PATENT APPLICATION

(11) **EP 4 766 036 A1**
(43) Date of publication of application: **24.06.2026**
(21) Application number: 25194520.0
(22) Date of filing: 07.08.2025
(51) Int. Cl.: H05K 1/11, H05K 1/14, H05K 3/36, H05K 3/42

(54) **SEMICONDUCTOR STORAGE DEVICE AND BOARD UNIT**

(30) Priority: 18.12.2024 JP 2024221349
(71) Applicant: Kioxia Corporation, Tokyo (JP)
(72) Inventor: NIITSUMA, Kazuyuki, Minato-ku, Tokyo (JP)
(74) Representative: Hoffmann Eitle

(57) **Abstract**

A semiconductor storage device according to one embodiment includes a first board and a second board. The first board includes a first portion, a second portion thinner than the first portion, and a plurality of first conductive portions on the second portion. The second board includes a plurality of second conductive portions. The plurality of second conductive portions overlap the plurality of first conductive portions when viewed from a first direction which is a thickness direction of the first board. The plurality of second conductive portions are connected to the plurality of first conductive portions by solder in one-to-one correspondence.

## Description

### CROSS-REFERENCE TO RELATED APPLICATION

Priority is claimed on Japanese Patent Application No. 2024-221349, filed December 18, 2024, the content of which is incorporated herein by reference.

### FIELD

The present invention relates to a semiconductor storage device and a board unit.

### BACKGROUND ART

A semiconductor storage device having a housing, a board housed in the housing, and a semiconductor memory provided on the board is known.

### BRIEF DESCRIPTION OF THE DRAWINGS

FIG. 1 is a perspective view showing a semiconductor storage device of a first embodiment.
FIG. 2 is a perspective view showing the semiconductor storage device of the first embodiment in a partially exploded manner.
FIG. 3 is a perspective view showing a board of the first embodiment in a partially exploded manner.
FIG. 4 is a cross-sectional view showing a part of the semiconductor storage device of the first embodiment.
FIG. 5 is a perspective view showing a connection structure between a first board and a second board of the first embodiment in an exploded manner.
FIG. 6 is an enlarged view showing the connection structure between the first board and the second board of the first embodiment.
FIG. 7 is an enlarged view showing the connection structure between the first board and the second board of the first embodiment.
FIG. 8A is a plan view for explaining a visual inspection method of the first embodiment.
FIG. 8B is a plan view for explaining the visual inspection method of the first embodiment.
FIG. 8C is a plan view for explaining the visual inspection method of the first embodiment.
FIG. 8D is a plan view for explaining the visual inspection method of the first embodiment.
FIG. 9 is a cross-sectional view for explaining an electrical inspection method of the first embodiment.
FIG. 10 is a cross-sectional view showing a part of a semiconductor storage device of a second embodiment.
FIG. 11 is a cross-sectional view showing a part of a semiconductor storage device of a third embodiment.
FIG. 12 is a cross-sectional view showing a part of a semiconductor storage device of a fourth embodiment.
FIG. 13 is a view showing a part of a semiconductor storage device of a sixth embodiment in an exploded manner.
FIG. 14 is a view showing a part of the semiconductor storage device of the sixth embodiment.
FIG. 15 is a view showing a part of a semiconductor storage device of a sixth embodiment in an exploded manner.
FIG. 16 is a view showing a part of the semiconductor storage device of the sixth embodiment.

### DETAILED DESCRIPTION

A semiconductor storage device according to one embodiment includes a first board and a second board. The first board has a first portion, a second portion thinner than the first portion, and a plurality of first conductive portions on the second portion. The second board has a plurality of second conductive portions. The plurality of second conductive portions overlap the plurality of first conductive portions when viewed from a first direction which is a thickness direction of the first board. The plurality of second conductive portions are connected to the plurality of first conductive portions by solder in one-to-one correspondence.

Hereinafter, a semiconductor storage device and a board unit of an embodiment will be described with reference to the drawings. In the following description, components having the same or similar functions will be denoted by the same reference signs. Also, duplicate description of the components may be omitted.

In the present application, terms are defined as follows. "Connection" is not limited to a case of being mechanically connected, and may also include a case of being electrically connected. That is, "connection" is not limited to a case in which two elements to be connected are directly connected, and may include a case in which two elements to be connected are connected with another element interposed therebetween. "Facing" or "overlapping" means that virtual projection images of two objects overlap each other when viewed from a particular direction. In other words, "facing" or "overlapping" is not limited to a case in which two objects directly face each other, and may also include a case in which two objects face each other with another member or a gap interposed between the two objects. "Parallel", "orthogonal", or "the same" may include a case of "substantially parallel", "substantially orthogonal", or "substantially the same".

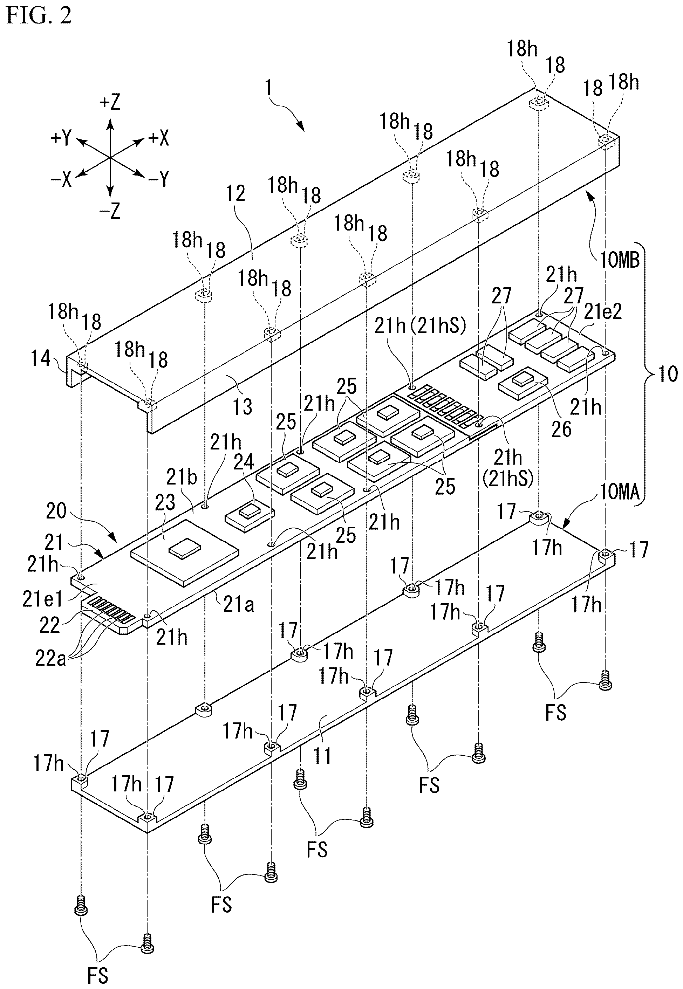

In the present application, a +X direction, a -X direction, a +Y direction, a -Y direction, a +Z direction, and a -Z direction are defined as follows. The +X direction, the -X direction, the +Y direction, and the -Y direction are directions parallel to a first surface 21a of a board 21 to be described later (refer to FIG. 2). The +X direction is a direction from a first end part 21e1 to a second end part 21e2 of the board 21 (refer to FIG. 2). The -X direction is a direction opposite to the +X direction. In a case in which the +X direction and the -X direction do not need to be distinguished from each other, they will be simply referred to as the "X direction". The +Y direction and the -Y direction are directions intersecting (for example, orthogonal to) the X direction. The +Y direction is a direction toward a second side wall 14 from a first side wall 13 of a housing 10 to be described later (refer to FIG. 2). The -Y direction is a direction opposite to the +Y direction. In a case in which the +Y direction and the -Y direction do not need to be distinguished from each other, they will be simply referred to as the "Y direction". The +Z direction and the -Z direction are directions intersecting (for example, orthogonal to) the X direction and the Y direction. The +Z direction is a direction toward a second surface 21b from the first surface 21a of the board 21 (refer to FIG. 2). The -Z direction is a direction opposite to the +Z direction. In a case in which the +Z direction and the -Z direction do not need to be distinguished from each other, they will be simply referred to as the "Z direction". The Z direction is a thickness direction of the board 21. The Z direction is an example of a "first direction". A side in the -Z direction is an example of a "first side". A side in the +Z direction is an example of a "second side". The X direction is an example of a "second direction".

### (First embodiment)

### <1. Overall configuration of semiconductor storage device>

First, a semiconductor storage device 1 according to a first embodiment will be described. The semiconductor storage device 1 is, for example, a storage device such as a solid state drive (SSD). The semiconductor storage device 1 is connected to a host device and is used as a storage device for the host device. The host device may be a personal computer, a mobile device, a video recorder, an in-vehicle device, or the like, but is not limited to these examples.

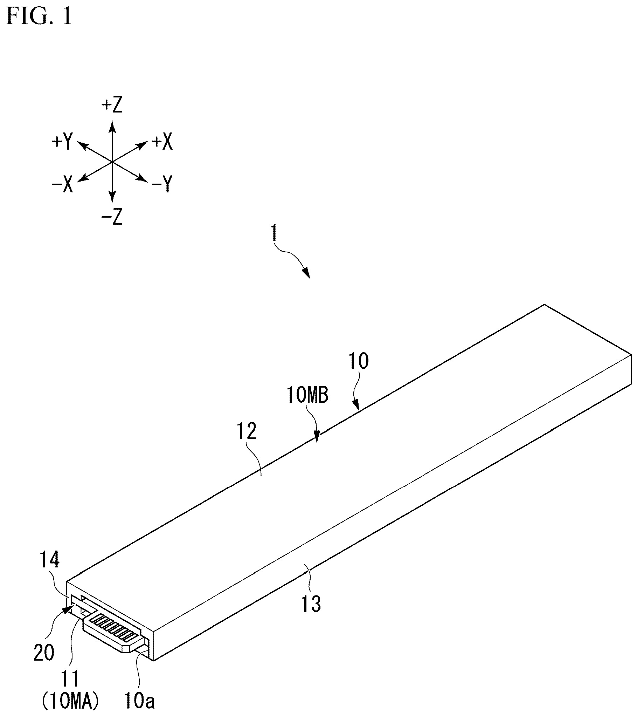

FIG. 1 is a perspective view showing the semiconductor storage device 1. The semiconductor storage device 1 includes, for example, a housing 10 and a board unit 20. <1.1 Housing>

The housing 10 is a member that houses the board unit 20. The housing 10 is, for example, a metal member formed in a cylindrical shape. The housing 10 has, for example, a first main wall 11, a second main wall 12, a first side wall 13, and a second side wall 14.

FIG. 2 is a perspective view showing the semiconductor storage device 1 in a partially exploded manner. The first main wall 11 is a plate-shaped wall extending in the X direction and the Y direction. The first main wall 11 faces the board unit 20 from the side in the -Z direction. The second main wall 12 is a plate-shaped wall extending in the X direction and the Y direction. The second main wall 12 is positioned on a side opposite to the first main wall 11 with respect to the board unit 20. The second main wall 12 faces the board unit 20 from the side in the +Z direction.

The first side wall 13 is a plate-shaped wall extending in the X direction and the Z direction. The first side wall 13 faces the board unit 20 from the side in the -Y direction. The second side wall 14 is a plate-shaped wall extending in the X direction and the Z direction. The second side wall 14 is positioned on a side opposite to the first side wall 13 with respect to the board unit 20. The second side wall 14 faces the board unit 20 from the side in the +Y direction.

In the embodiment, a base member 10MA is formed by the first main wall 11. On the other hand, a cover member 10MB is formed by the second main wall 12, the first side wall 13, and the second side wall 14. In the embodiment, the cylindrical housing 10 is formed by combining the base member 10MA and the cover member 10MB. Furthermore, a shape of the housing 10 is not limited to the above-described embodiment.

As shown in FIG. 2, the first main wall 11 has a plurality of fixing portions 17. The fixing portions 17 are portions for fixing a board 21 to be described later to the housing 10. The plurality of fixing portions 17 are disposed separately in the X direction and the Y direction along an outer shape of the board 21. The fixing portions 17 each protrude in the +Z direction from the first main wall 11. Each fixing portion 17 has a fixing hole 17h into which a fastening member FS is inserted. The fixing hole 17h is, for example, an insertion hole that does not have a thread groove. The fixing hole 17h penetrates the first main wall 11 and the fixing portion 17 in the Z direction.

The second main wall 12 has a plurality of fixing portions 18. The fixing portions 18 are portions for fixing the board 21 to the housing 10. The plurality of fixing portions 18 are disposed separately in the X direction and the Y direction along the outer shape of the board 21. The plurality of fixing portions 18 are disposed at positions overlapping the plurality of fixing portions 17 in a one-to-one relationship when viewed in the Z direction. The fixing portions 18 each protrude in the -Z direction from the second main wall 12. Each fixing portion 18 has a fixing hole 18h into which the fastening member FS is inserted. The fixing hole 18h is, for example, an engagement hole having a thread groove. Furthermore, shapes of the fixing portions 17 and 18 are not limited to the above-described embodiment. For example, the fixing hole 18h of the fixing portion 18 may be an insertion hole that does not have a thread groove. The fixing hole 17h of the fixing portion 17 may be an engagement hole having a thread groove.

### <1.2 Board unit>

Next, the board unit 20 will be described. The board unit 20 is an assembly on which components including circuits are mounted. The board unit 20 includes, for example, the board 21, a connection connector 22, a controller 23, one or more dynamic random access memories (DRAMs) 24, a plurality of NAND flash memories 25 (hereinafter referred to as "NANDs 25"), a power supply control component 26, and a plurality of capacitors 27.

The board 21 is a plate member extending along the X and Y directions. The board 21 is a printed wiring board. The board 21 includes an insulating base material and a wiring pattern provided on the insulating base material. The board 21 has a first surface 21a and a second surface 21b positioned on a side opposite to the first surface 21a. The first surface 21a and the second surface 21b are surfaces extending in the X direction and the Y direction. The first surface 21a is a surface facing in the -Z direction. The second surface 21b is a surface facing in the +Z direction.

The board 21 has a first end part 21e1 and a second end part 21e2 as end parts of the board 21 in a longitudinal direction (X direction). The first end part 21e1 is an end part of the board 21 on the side in the -X direction. The second end part 21e2 is an end part of the board 21 on the side in the +X direction. For example, the entire board 21 has the same thickness. Furthermore, details of the board 21 will be described later.

The connection connector 22 is a connection portion connectable to a connector of the host device. The connection connector 22 includes a plurality of metal terminals 22a connectable to the connector of the host device. The connection connector 22 is provided, for example, at the first end part 21e1 of the board 21. The connection connector 22 is exposed to the outside of the housing 10 through an opening 10a of the housing 10 (refer to FIG. 1).

The controller 23 is a component that comprehensively controls the entirety of the semiconductor storage device 1. The controller 23 is a semiconductor package. The semiconductor package includes a system on a chip (SoC). In the SoC, for example, a host interface circuit for the host device, a control circuit for controlling the plurality of NANDs 25, and the like are integrated into a single semiconductor chip. The controller 23 is provided, for example, on the second surface 21b of the board 21.

In the embodiment, for example, a high-speed signal is transmitted between the connection connector 22 and the controller 23. The high-speed signal is, for example, a signal that conforms to a communication interface standard such as, for example, PCI Express (PCIe) (registered trademark) or serial advanced technology attachment (SATA).

The DRAM 24 is a data buffer. Write target data received from the host device, read target data read from the NAND 25, or the like is temporarily stored in the data buffer. The number of the DRAMs 24 may be one or more. Also, the DRAM 24 may be provided inside the controller 23 as a part of the controller 23 instead of being provided as a separate part from the controller 23.

The NAND 25 is a semiconductor package that includes a nonvolatile semiconductor memory chip. The plurality of NANDs 25 include, for example, a plurality of NANDs 25 provided on the first surface 21a of the board 21 and a plurality of NANDs 25 provided on the second surface 21b of the board 21. The NAND 25 is an example of a "semiconductor memory". Furthermore, the "semiconductor memory" as used in the present application is not limited to the NAND 25, but may be other types of semiconductor memory such as a NOR type memory, a magnetoresistive random access memory (MRAM), or a resistive memory.

The power supply control component 26 controls power supply to the controller 23, the DRAM 24, and the plurality of NANDs 25. The power supply control component 26 is a semiconductor package. A plurality of power supply circuits required for supplying power to, for example, the controller 23, the DRAM 24, or the NAND 25 are integrated into one semiconductor chip in the semiconductor package. The power supply control component 26 receives power from the outside via, for example, the connection connector 22 and distributes the received power within the board unit 20. The control component 26 is, for example, a power management IC (PMIC).

The capacitor 27 serves a power backup function for the purpose of data protection in the event of an unexpected power cutoff. When power supply from the host device is unexpectedly cut off, the capacitor 27 supplies power to the controller 23, the plurality of DRAMs 24, and the plurality of NANDs 25 for a certain period of time.

### <2. Divided structure of board>

Next, a divided structure of the board 21 will be described.

### <2.1 Overview of first board and second board>

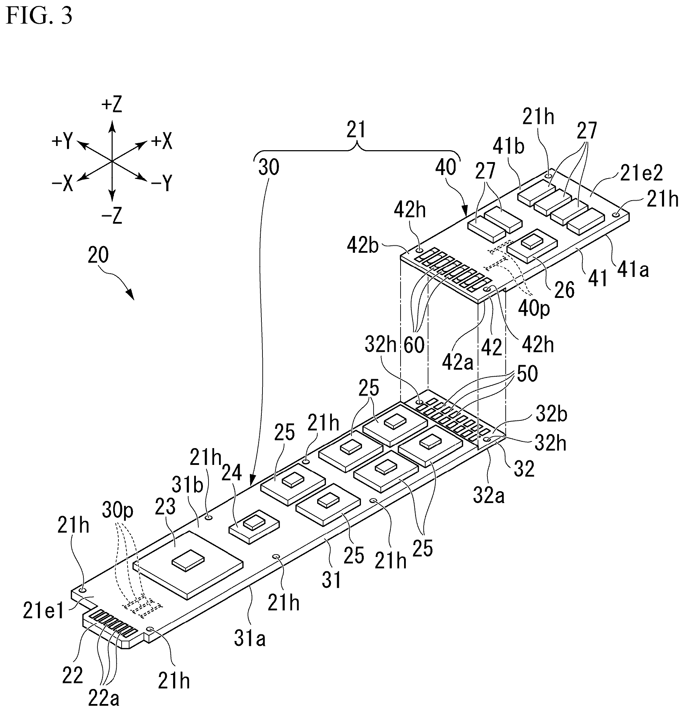

FIG. 3 is a perspective view showing the board 21 in a partially exploded manner. In the embodiment, the board 21 is divided into a first board 30 and a second board 40, for example, according to a plurality of purposes required for the board 21. In the embodiment, the first board 30 and the second board 40 are made of different materials depending on the purpose.

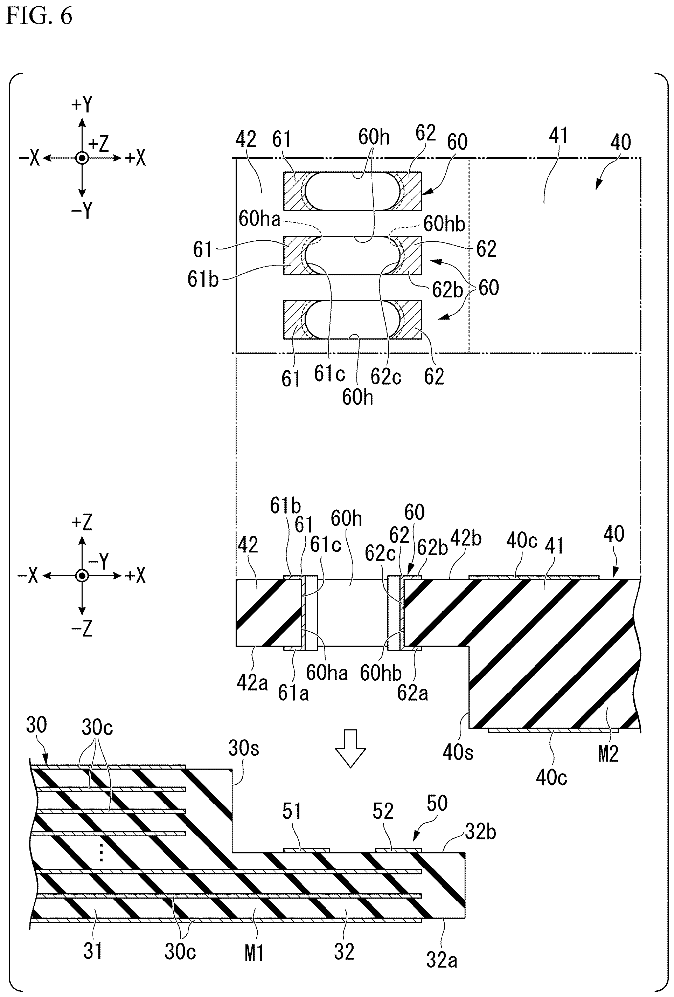

The first board 30 is a printed wiring board. The first board 30 includes an insulating base material and a wiring pattern provided on the insulating base material. The first board 30 is, for example, a board intended to reduce transmission loss of a high-speed signal. The first board 30 contains a first material M1 (refer to FIG. 6). The first material M1 is a low-loss material used as a material for the insulating base material. The material M1 is a material in which at least one of a dielectric constant and a dielectric loss tangent is smaller than that of a second material M2 to be described later. The first material M1 is, for example, a fluorine-based resin. However, the first material M1 is not limited to the above-described embodiment.

In the embodiment, the connection connector 22, the controller 23, the DRAM 24, and the plurality of NANDs 25 are provided on the first board 30. The first board 30 has, for example, a signal line 30p through which a high-speed signal is transmitted. In the present application, the "high-speed signal" is, for example, a signal conforming to a communication interface standard such as PCIe or SATA as described above. However, the "high-speed signal" in the present application is not limited to the above-described embodiment. The "high speed signal" is, for example, a signal related to data writing or data reading. The "high-speed signal" may be a signal that is, for example, only required to be faster than a signal transmitted from the power supply control component 26 to be described later. The first board 30 is, for example, a 16-layer buildup board. The first board 30 includes 16 conductive layers 30c stacked in the Z direction (refer to FIG. 6).

The second board 40 is a printed wiring board. The second board 40 includes an insulating base material and a wiring pattern provided on the insulating base material. The second board 40 is a board intended to reduce costs of the board 21. The second board 40 contains the second material M2. The second material M2 is a general-purpose material used as a material for the insulating base material (refer to FIG. 6). The second material M2 is a material that is less expensive than the first material M1 described above. The second material M2 is, for example, a glass epoxy resin, a phenol resin, or the like. However, the second material M2 is not limited to the above-described embodiment.

In the embodiment, the power supply control component 26 and the plurality of capacitors 27 are provided on the second board 40. The second board 40 has, for example, a signal line 40p through which a non-high-speed signal is transmitted. In the present application, the "non-high-speed signal" is a signal related to the power supply. For example, the "non-high-speed signal" is a signal transmitted from the power supply control component 26. The second board 40 is, for example, a two-layer through board. The second board 40 includes two conductive layers 40c stacked in the Z direction (refer to FIG. 6). The number of the multi-layers in the conductive layers 40c of the second board 40 is different from the number of the multi-layers in the conductive layers 30c of the first board 30. For example, the number of the multi-layers in the conductive layer 40c of the second board 40 is smaller than the number of the multi-layers in the conductive layer 30c of the first board 30.

### <2.2 Cross-sectional shape of first board>

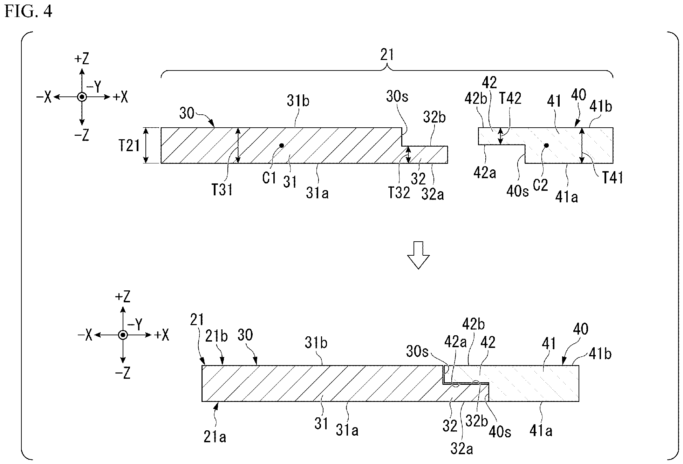

FIG. 4 is a cross-sectional view showing a part of the semiconductor storage device 1. The first board 30 includes, for example, a first portion 31 and a second portion 32.

### (First portion)

A thickness T31 of the first portion 31 in the Z direction is the same as a thickness T21 of the board 21 in the Z direction. The first portion 31 has a first surface 31a and a second surface 31b. The first surface 31a and the second surface 31b are surfaces extending in the X direction and the Y direction. The first surface 31a is a surface facing in the -Z direction. The first surface 31a forms a part of the first surface 21a of the board 21. On the other hand, the second surface 31b is a surface facing in the +Z direction. The second surface 31b forms a part of the second surface 21b of the board 21.

### (Second portion)

The second portion 32 is positioned on the side in the +X direction with respect to the first portion 31. The second portion 32 has a step 30s in the Z direction between itself and the first portion 31. The second portion 32 is thinner than the first portion 31. That is, a thickness T32 of the second portion 32 in the Z direction is smaller than the thickness T31 of the first portion 31 in the Z direction. In the embodiment, the second portion 32 is displaced to the side in the -Z direction with respect to a center C1 of the first portion 31 in the Z direction. The second portion 32 is formed, for example, by cutting a part of the second board 40 through mechanical processing or laser processing. However, a manufacturing method of the second portion 32 is not limited to the above-described embodiment.

The second portion 32 has a first surface 32a and a second surface 32b. The first surface 32a and the second surface 32b are surfaces extending in the X direction and the Y direction. The first surface 32a is a surface facing in the -Z direction. In the embodiment, the first surface 32a is positioned on the same plane as the first surface 31a of the first portion 31 described above. The first surface 32a forms a part of the first surface 21a of the board 21. Electronic components may be mounted on the first surface 32a. On the other hand, the second surface 32b is a surface facing in the +Z direction. The second surface 32b is positioned at a different height from the second surface 31b of the first portion 31 described above. There is the above-described step 30s between the second surface 32b and the second surface 31b of the first portion 31.

### <2.3 Cross-sectional shape of second board>

The second board 40 includes, for example, a third portion 41 and a fourth portion 42.

### (Third portion)

A thickness T41 of the third portion 41 in the Z direction is the same as the thickness T21 of the board 21 in the Z direction. The third portion 41 has a first surface 41a and a second surface 41b. The first surface 41a and the second surface 41b are surfaces extending in the X direction and the Y direction. The first surface 41a is a surface facing in the -Z direction. The first surface 41a is positioned on the same plane as the first surface 31a of the first portion 31 and the first surface 32a of the second portion 32. The first surface 41a forms a part of the first surface 21a of the board 21. In the embodiment, the first surface 21a of the board 21 is formed by the first surface 31a of the first portion 31, the first surface 32a of the second portion 32, and the first surface 41a of the third portion 41. On the other hand, the second surface 41b is a surface facing in the +Z direction. The second surface 41b is positioned on the same plane as the second surface 31b of the first portion 31. The second surface 41b forms a part of the first surface 21a of the board 21.

### (Fourth portion)

The fourth portion 42 is positioned on the side in the -X direction with respect to the third portion 41. The fourth portion 42 overlaps the second portion 32 of the first board 30 when viewed from the Z direction. The fourth portion 42 has a step 40s in the Z direction between itself and the third portion 41. The fourth portion 42 is thinner than the third portion 41. That is, a thickness T42 of the fourth portion 42 in the Z direction is smaller than the thickness T41 of the third portion 41 in the Z direction. In the embodiment, the fourth portion 42 is displaced to the side in the +Z direction with respect to a center C2 of the third portion 41 in the Z direction.

The fourth portion 42 has a first surface 42a and a second surface 42b. The first surface 42a and the second surface 42b are surfaces extending in the X direction and the Y direction. The first surface 42a is a surface facing in the -Z direction. The first surface 42a is positioned at a different height from the first surface 41a of the third portion 41 described above. Between the first surface 42a and the first surface 41a of the third portion 41, there is the step 40s described above. The first surface 42a faces the second surface 32b of the second portion 32 of the first board 30 in the Z direction. On the other hand, the second surface 42b is a surface facing in the +Z direction. The second surface 42b is positioned on the same plane as the second surface 31b of the first portion 31 and the second surface 41b of the third portion 41. The second surface 42b forms a part of the second surface 21b of the board 21. Electronic components may be mounted on the second surface 42b. **In** the embodiment, the second surface 21b of the board 21 is formed by the second surface 31b of the first portion 31, the second surface 41b of the third portion 41, and the second surface 42b of the fourth portion 42.

### <3. Connection structure between first board and second board>

Next, a connection structure between the first board 30 and the second board 40 will be described.

### <3.1 First conductive portion>

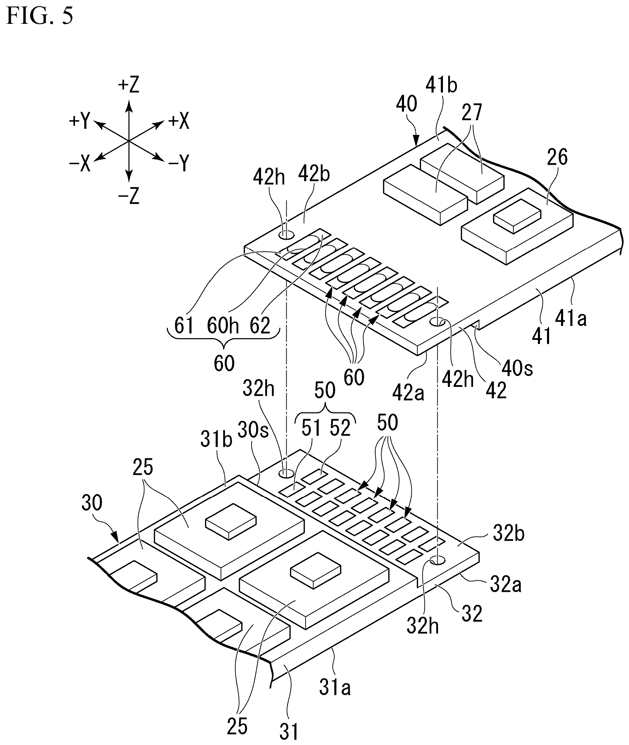

FIG. 5 is a perspective view showing a connection structure between the first board 30 and the second board 40 in an exploded manner. **In** the embodiment, the first board 30 includes a plurality of (for example, eight) pads 50. The plurality of pads 50 are provided on the second surface 32b of the second portion 32 of the first board 30 and are exposed to the outside of the first board 30. The plurality of (for example, eight) pads 50 are disposed, for example, to be aligned at intervals in the Y direction. The pads 50 are each a metal foil (for example, a copper foil) provided on the second surface 32b. The pad 50 is an example of a "first conductive portion".

In the embodiment, each pad 50 has a first portion 51 and a second portion 52. The first portion 51 and the second portion 52 are disposed at a distance from each other in the X direction. The first portion 51 and the second portion 52 are each formed, for example, in a rectangular shape in the X direction. The first portion 51 and the second portion 52 are electrically connected to each other via the conductive layer 30c in the first board 30 (refer to FIG. 6). Alternatively, the first portion 51 and the second portion 52 may not be electrically connected to each other in the first board 30. Also, instead of a structure having the first portion 51 and the second portion 52 divided to each other, the pad 50 may be formed of a single continuous conductor portion including the first portion 51 and the second portion 52.

### <3.2 Second conductive portion>

In the embodiment, the second board 40 has a plurality of (for example, eight) lands 60. The plurality of lands 60 are provided on a surface (for example, the first surface 42a and the second surface 42b) of the fourth portion 42 of the second board 40 and are exposed to the outside of the second board 40. The plurality of (for example, eight) lands 60 are disposed, for example, to be aligned at intervals in the Y direction.

At least a part of each land 60 is a metal foil (for example, a copper foil) provided on a surface (for example, the first surface 42a and the second surface 42b) of the second board 40. The plurality of lands 60 overlap the plurality of pads 50 in a one-to-one relationship when viewed from the Z direction. The land 60 is an example of a "second conductive portion".

FIG. 6 is an enlarged view showing the connection structure between the first board 30 and the second board 40. FIG. 6 shows a state before the first board 30 and the second board 40 are connected. In the embodiment, each land 60 has a through hole 60h, a first part 61, and a second part 62. The through hole 60h is provided at a central part of the land 60. The through hole 60h penetrates the second board 40 in the Z direction. The through hole 60h is an elongated hole extending in a longitudinal direction thereof in the X direction. The through hole 60h has a first end part 60ha positioned on the side in the -X direction and a second end part 60hb positioned on the side in the +X direction.

The first part 61 and the second part 62 are disposed separately on opposite sides of the through hole 60h in the X direction. For example, the first part 61 is provided adjacent to the first end part 60ha of the through hole 60h. The second part 62 is separated from the first part 61 and is provided adjacent to the second end part 60hb of the through hole 60h. The first part 61 and the second part 62 are not electrically connected to each other on the second board 40. That is, the first part 61 and the second part 62 are insulated from each other on the second board 40.

The first part 61 has, for example, a first metal part 61a, a second metal part 61b, and a third metal part 61c. The first metal part 61a is a metal foil provided on the first surface 42a of the fourth portion 42. The second metal part 61b is a metal foil provided on the second surface 42b of the fourth portion 42. The third metal part 61c is a metal foil provided on an inner surface of the first end part 60ha of the through hole 60h. The first metal part 61a, the second metal part 61b, and the third metal part 61c are, for example, provided to be continuous with each other.

The second part 62 has, for example, a first metal part 62a, a second metal part 62b, and a third metal part 62c. The first metal part 62a is a metal foil provided on the first surface 42a of the fourth portion 42. The second metal part 62b is a metal foil provided on the second surface 42b of the fourth portion 42. The third metal part 61c is a metal foil provided on an inner surface of the second end part 60hb of the through hole 60h. The first metal part 62a, the second metal part 62b, and the third metal part 62c are, for example, provided to be continuous with each other.

### <3.3 Solder connection portion>

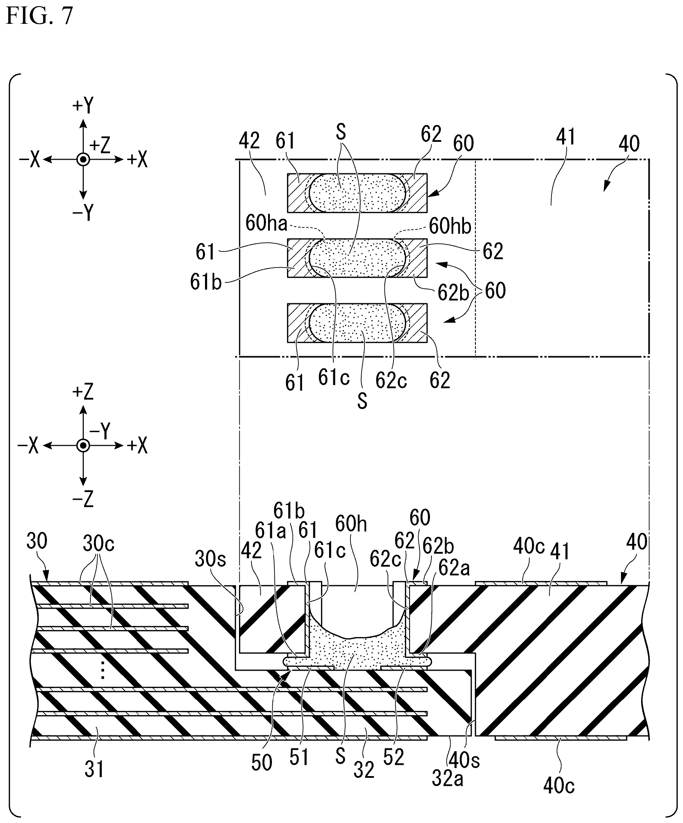

FIG. 7 is an enlarged view showing the connection structure between the first board 30 and the second board 40. FIG. 7 shows a state in which the first board 30 and the second board 40 are connected. In the embodiment, the pad 50 and the land 60 are connected by solder. For example, a solder connection portion S is provided between the pad 50 and the land 60. The plurality of pads 50 and the plurality of lands 60 are physically and electrically connected in a one-to-one relationship via a plurality of solder connection portions S.

In the embodiment, a part of the solder connection portion S is positioned between the first portion 51 of the pad 50 and the first part 61 of the land 60. A part of the solder connection portion S connects the first portion 51 of the pad 50 and the first part 61 of the land 60. For example, a part of the solder connection portion S is joined to the first part 61 of the land 60 across the first metal part 61a and the third metal part 61c of the first part 61 of the land 60.

Another part of the solder connection portion S is positioned between the second portion 52 of the pad 50 and the second part 62 of the land 60. Another part of the solder connection portion S connects the second portion 52 of the pad 50 and the second part 62 of the land 60. For example, a part of the solder connection portion S is joined to the second part 62 of the land 60 across the first metal part 62a and the third metal part 62c of the second part 62 of the land 60.

Also, the solder connection portion S is positioned between the first part 61 and the second part 62 of the land 60 in the X direction. The solder connection portion S connects the first part 61 and the second part 62 of the land 60.

### <4. Fixing structure to housing>

Next, returning to FIG. 2, a method for fixing the board 21 to the housing 10 will be described. The board 21 has a plurality of fixing holes 21h. The plurality of fixing holes 21h are disposed separately along the outer shape of the board 21. The plurality of fixing holes 21h are disposed at positions overlapping the plurality of fixing portions 17 and 18 of the housing 10 when viewed from the Z direction. Each of the fixing holes 21h is a through hole that penetrates the board 21 in the Z direction. **In** the embodiment, the fastening member FS passed through the fixing hole 17h of the fixing portion 17 of the base member 10MA passes through the fixing hole 21h of the board 21 and engages with the fixing hole 18h of the fixing portion 18 of the cover member 10MB. Due to this engagement, the base member 10MA and the cover member 10MB are fixed while the board 21 is sandwiched from both sides in the Z direction by the fixing portion 17 of the base member 10MA and the fixing portion 18 of the cover member 10MB. Therefore, the board 21 is fixed to the housing 10.

**In** the embodiment, the plurality of fixing holes 21h each include a fixing hole 21hS provided in the connection portion between the first board 30 and the second board 40.

As shown in FIG. 3, the second portion 32 of the first board 30 has two fixing holes 32h. The fixing hole 32h is provided at a position corresponding to the fixing hole 21hS when viewed from the Z direction. The fixing hole 32h is an example of a "first hole".

Similarly, the fourth portion 42 of the second board 40 has two fixing holes 42h. The fixing hole 42h is provided at a position corresponding to the fixing hole 21hS when viewed from the Z direction. The fixing hole 42h of the second board 40 faces the fixing hole 32h of the first board 30 in the Z direction. The fixing hole 42h is an example of a "second hole". In the embodiment, the fixing hole 21hS is formed by the fixing hole 32h of the first board 30 and the fixing hole 42h of the second board 40.

In the embodiment, the fastening member FS passed through the fixing hole 17h of the base member 10MA passes through the fixing hole 32h of the first board 30 and the fixing hole 42h of the second board 40 and engages with the fixing hole 18h of the cover member 10MB. Due to this engagement, the base member 10MA and the cover member 10MB are fixed while the second portion 32 of the first board 30 and the fourth portion 42 of the second board 40 are sandwiched from both sides in the Z direction by the fixing portion 17 of the base member 10MA and the fixing portion 18 of the cover member 10MB. Therefore, the connection portion between the first board 30 and the second board 40 are fixed to the housing 10.

### <5. Manufacturing method of semiconductor storage device>

### <5.1 Flow of manufacturing method>

First, the first board 30 and the second board 40 are prepared separately. Then, the second portion 32 of the first board 30 and the fourth portion 42 of the second board 40 are connected. For example, the first board 30 and the second board 40 are held by a jig in a state in which the second portion 32 of the first board 30 and the fourth portion 42 of the second board 40 are overlapped in the Z direction. Then, solder is supplied to the through hole 60h of each land 60 of the second board 40. Therefore, the second portion 32 of the first board 30 and the fourth portion 42 of the second board 40 are connected by the solder connection portion S. Therefore, the board 21 is formed.

Next, the controller 23, the DRAM 24, the plurality of NANDs 25, the power supply control component 26, and the plurality of capacitors 27 are mounted on the board 21. Furthermore, mounting of these electronic components may be performed before the first board 30 and the second board 40 are connected to each other. Also, as part of a process of mounting these electronic components, a process of connecting the first board 30 and the second board 40 may be performed. Then, the housing 10 is assembled so that the board 21 is sandwiched between the base member 10MA and the cover member 10MB. Next, inspection of the semiconductor storage device 1 is performed. Therefore, the semiconductor storage device 1 is completed.

### <5.2 Inspection method>

Next, an inspection method for the semiconductor storage device 1 will be described. In the embodiment, an inspection method for the semiconductor storage device 1 includes inspection of a connection state between the second portion 32 of the first board 30 and the fourth portion 42 of the second board 40. This inspection may be performed by at least one of visual inspection and electrical inspection.

### <5.2.1 Visual inspection method>

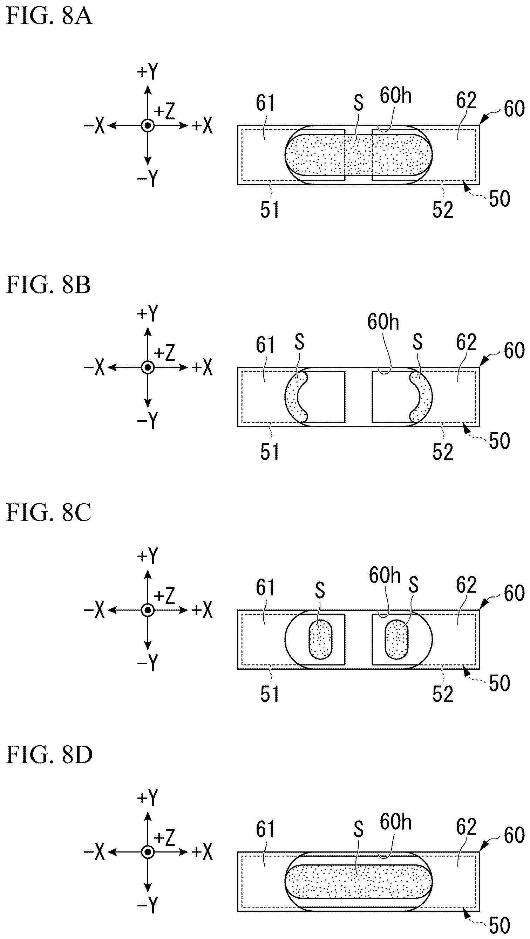

FIGS. 8A to 8D are plan views for explaining a visual inspection method. In the embodiment, the solder connection portion S can be visually recognized from outside the board 21 through the through hole 60h of the land 60 of the second board 40. Furthermore, in the present application, "visual inspection" is not limited to directly viewing the board 21, and may also include viewing using a magnifying glass or viewing an image captured by an imaging device.

FIG. 8A shows a case in which a connection state between the first board 30 and the second board 40 is satisfactory. For example, if the solder connection portion S is present inside the through hole 60h across the first part 61 and the second part 62 of the land 60, it can be understood that a sufficient amount of solder has been properly supplied. In this case, it can be determined that the connection state between the first board 30 and the second board 40 is satisfactory.

FIG. 8B shows a case in which the connection state between the first board 30 and the second board 40 is poor. For example, if the solder connection portion S is in contact with the first part 61 or the second part 62 of the land 60 inside the through hole 60h while the solder connection portion S is disconnected between the first part 61 and the second part 62 of the land 60, it can be understood that the amount of solder is insufficient. **In** this case, it can be determined that the connection state between the first board 30 and the second board 40 is poor.

FIG. 8C shows a case in which the connection state between the first board 30 and the second board 40 is poor. For example, if the solder connection portion S is not in contact with the first part 61 or the second part 62 of the land 60 inside the through hole 60h, and the solder connection portion S is disconnected between the first part 61 and the second part 62 of the land 60, it can be understood that the amount of solder is insufficient. In this case, it can be determined that the connection state between the first board 30 and the second board 40 is poor.

FIG. 8D shows a case in which the pad 50 is formed of a single conductor portion (that is, not divided into the first portion 51 and the second portion 52) and the connection state between the first board 30 and the second board 40 is satisfactory. For example, if the solder connection portion S is present inside the through hole 60h across the first part 61 and the second part 62 of the land 60, it can be understood that a sufficient amount of solder has been properly supplied. In this case, it can be determined that the connection state between the first board 30 and the second board 40 is satisfactory.

### <5.2.2 Electrical inspection>

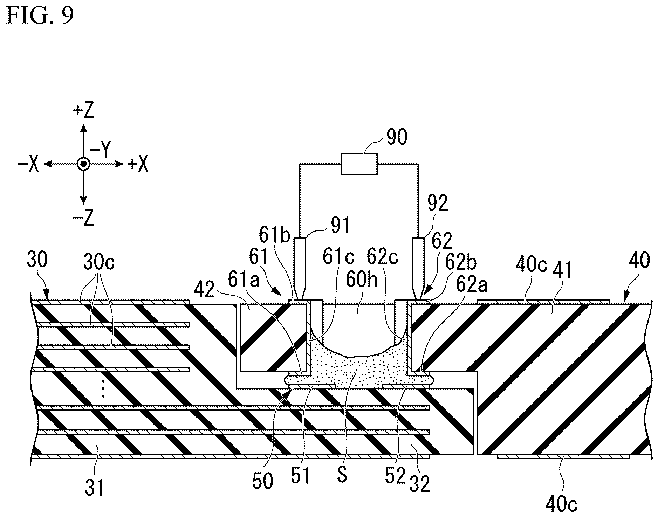

FIG. 9 is a cross-sectional view for explaining an electrical inspection method. In the embodiment, the connection state between the first board 30 and the second board 40 can be inspected by checking electrical continuity between the first part 61 and the second part 62 of the land 60. For example, a first terminal 91 of an inspection device 90 is brought into contact with the second metal part 61b of the first part 61 of the land 60 and a second terminal 92 of the inspection device 90 is brought into contact with the second metal part 62b of the second part 62 of the land 60 to check the electrical continuity between the first part 61 and the second part 62 of the land 60.

In this case, if electrical continuity is obtained between the first part 61 and the second part 62 of the land 60, it can be understood that a sufficient amount of solder has been properly supplied. In this case, it can be determined that the connection state between the first board 30 and the second board 40 is satisfactory. On the other hand, if electrical continuity is not obtained between the first part 61 and the second part 62 of the land 60, it can be understood that an amount of solder is insufficient. In this case, it can be determined that the connection state between the first board 30 and the second board 40 is poor.

### <6. Advantages>

As a first comparative embodiment, a board that is not divided into the first board 30 and the second board 40 will be considered. In such a configuration of the first comparative embodiment, a material or thickness of the board is the same across the entire board, and thus it may be difficult to improve a degree of freedom in terms of design, component replacement, or the like. For example, when the entire board is formed of an expensive material suitable for a high-speed signal, electronic components that do not require support for a high-speed signal will also be mounted on the board formed of the expensive material. In this case, the board may be over-specified for some components.

Therefore, as a second comparative embodiment, it is conceivable to divide the board into the first board 30 and the second board 40, and connect the first board 30 and the second board 40 via a connector component (for example, a B to B connector). However, when a connector component is used to connect the first board 30 and the second board 40, the semiconductor storage device becomes larger in size and it becomes difficult to reduce costs.

On the other hand, in the embodiment, the semiconductor storage device 1 includes the first board 30 and the second board 40. The first board 30 includes the first portion 31, the second portion 32 that is thinner than the first portion 31, and the plurality of pads 50 provided on the second portion 32. The second board 40 has the plurality of lands 60. The plurality of lands 60 overlap the plurality of pads 50 when viewed from the Z direction. The plurality of lands 60 are each connected to the plurality of pads 50 by solder. According to such a configuration, the board 21 can be divided into the first board 30 and the second board 40 according to the intended purpose, and materials or thicknesses of the first board 30 and the second board 40 can be varied. Therefore, compared to a board that is not divided into the first board 30 and the second board 40, a degree of freedom in design or the like can be improved.

In another example, the second board 40 may be replaceable with respect to the first board 30. In this case, compared to a board that is not divided into the first board 30 and the second board 40, a degree of freedom in component replacement or the like can be improved. In this case, when a malfunction occurs in electronic components provided on the second board 40, the board 21 can be repaired by replacing the second board 40.

Also, according to the structure in which the first board 30 and the second board 40 are connected by the solder connection portion S, the connection structure between the first board 30 and the second board 40 can be made thinner compared to a case in which a connector component is used. Also, as in the embodiment, the first board 30 has the second portion 32 that is thinner than the first portion 31, and the plurality of pads 50 are provided on the second portion 32, thereby making it possible to achieve further thinning of the connection structure between the first board 30 and the second board 40.

In the embodiment, the second board 40 has the third portion 41 and the fourth portion 42 that is thinner than the third portion 41 and overlaps the second portion 32 of the first board 30 when viewed from the Z direction. A plurality of lands 60 are provided on the fourth portion 42. According to such a configuration, a thickness of the connection structure between the first board 30 and the second board 40 can be made smaller than when the entire second board 40 has the same thickness.

In the embodiment, the second portion 32 of the first board 30 is displaced to the side in the -Z direction with respect to the center C1 of the first portion 31 of the first board 30 in the Z direction. On the other hand, the fourth portion 42 of the second board 40 is displaced to the side in the +Z direction with respect to the center C2 of the third portion 41 of the second board 40 in the Z direction. According to such a configuration, since the step 30s of the first board 30 and the step 40s of the second board 40 are steps in opposite directions, a total thickness of the board 21 can be made smaller than when the step 30s of the first board 30 and the step 40s of the second board 40 are steps in the same direction.

In the embodiment, the controller 23, the DRAM 24, and the NAND 25 are provided on the first board 30, and the power supply control component 26 is provided on the second board 40. According to such a configuration, the first board 30 can be structured to be suitable for transmitting a high-speed signal while the second board 40 can be structured to be less expensive than the first board 30. Therefore, it is possible to achieve enhancement of functionality and cost reduction of the semiconductor storage device 1. Here, the less expensive structure is at least one of, for example, a structure made of less expensive materials and a structure with a small number of multi-layered conductive layers.

In the embodiment, the controller 23, the DRAM 24, and the NAND 25 are provided on the first board 30, and the capacitor 27 is provided on the second board 40. According to such a configuration, the first board 30 can be structured to be suitable for transmitting a high-speed signal while the second board 40 can be structured that is less expensive than the first board 30. Therefore, it is possible to simultaneously achieve enhancement of functionality and cost reduction for the semiconductor storage device 1. Here, the less expensive structure is at least one of, for example, a structure made of less expensive materials and a structure with a small number of multi-layered conductive layers.

In the embodiment, the first board 30 contains the first material M1. The second board 40 includes the second material M2. The first material M1 has at least one of a lower dielectric constant and a lower dielectric loss tangent compared to the second material M2. According to such a configuration, the first board 30 can be structured to be suitable for transmitting a high-speed signal while the second board 40 can be made of a material that is less expensive than the first board 30. Therefore, it is possible to simultaneously achieve enhancement of functionality and cost reduction for the semiconductor storage device 1.

In the embodiment, the first board 30 has the pads 50. The second board 40 has the lands 60. The lands 60 each include the through hole 60h penetrating the second board 40 in the Z direction. According to such a configuration, solder can be supplied between the first board 30 and the second board 40 through the through hole 60h of the land 60. Therefore, it is possible to improve manufacturability of the semiconductor storage device 1.

In the embodiment, the through hole 60h is an elongated hole extending in a longitudinal direction thereof in the X direction (or Y direction). According such a configuration, when a state of the solder connection portion S in the longitudinal direction of the elongated hole is visually or electrically checked, it becomes easier to inspect the connection state between the first board 30 and the second board 40. Therefore, it is possible to improve manufacturability of the semiconductor storage device 1.

In the embodiment, the through hole 60h is an elongated hole described above. The through hole 60h includes the first end part 60ha and the second end part 60hb. The first end part 60ha is positioned on one side in the X direction (or Y direction). The second end part 60hb is positioned on the other side in the X direction (or Y direction). The land 60 includes the first part 61 adjacent to the first end part 60ha of the through hole 60h, and the second part 62 separated from the first part 61 and adjacent to the second end part 60hb of the through hole 60h. According to such a configuration, it becomes easier to inspect the connection state between the first board 30 and the second board 40. Specifically, when the connection state of the solder connection portion S with respect to the first part 61 and the second part 62 of the land 60 is visually checked, it becomes easier to inspect the connection state between the first board 30 and the second board 40. Also, when the electrical connection state between the first part 61 and the second part 62 of the land 60 is checked, it becomes easier to inspect the connection state between the first board 30 and the second board 40. Therefore, it is possible to improve manufacturability of the semiconductor storage device 1.

In the embodiment, the housing 10 includes the fixing portions 17 and 18. The second portion 32 of the first board 30 has the fixing hole 32h. The second board 40 has the fixing hole 42h facing the fixing hole 32h. The fastening member FS is inserted into the fixing hole 32h and the fixing hole 42h to be fixed to the fixing portions 17 and 18. According to such a configuration, at least a part of the structure connecting the first board 30 and the second board 40 is formed by the fixing structure that fixes the board 21 to the housing 10. Therefore, it is possible to achieve reduction in size and cost of the semiconductor storage device 1 compared to a case in which the fixing structure for fixing the board 21 to the housing 10 and the structure for connecting the first board 30 and the second board 40 are provided separately.

In the embodiment, a part of the second portion 32 of the first board 30 and a part of the fourth portion 42 of the second board 40 are connected by solder (for example, a part of the solder connection portion S). On the other hand, another part of the second portion 32 of the first board 30 and another part of the fourth portion 42 of the second board 40 may be in contact with each other. Therefore, it is possible to achieve further thinning of the connection structure between the first board 30 and the second board 40.

Also, alternatively or additionally to the above-described embodiment, a part of the first portion 31 of the first board 30 (for example, the step 30s) and the fourth portion 42 of the second board 40 may be in contact with each other in the X direction. Therefore, it is possible to easily perform positioning between the first board 30 and the second board 40 in some cases. Also, alternatively or additionally to the above-described embodiment, a part of the third portion 41 of the second board 40 (for example, the step 40s) and the second portion 32 of the first board 30 may be in contact with each other in the X direction. Therefore, it is possible to easily perform positioning between the first board 30 and the second board 40 in some cases.

### (Second embodiment)

Next, a second embodiment will be described. Furthermore, configurations of the second embodiment other than those described below are the same as the configurations of the first embodiment.

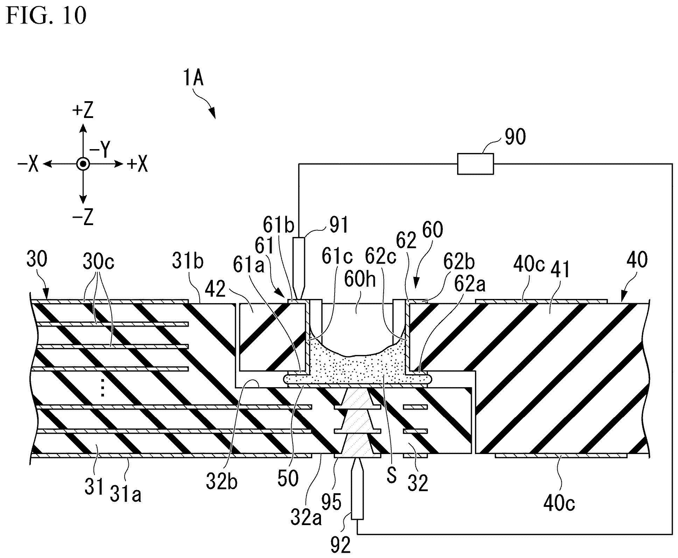

FIG. 10 is a cross-sectional view showing a part of a semiconductor storage device 1A of the second embodiment. In the second embodiment, for example, the pad 50 is formed of a single conductor portion. That is, the pad 50 is not divided into the first portion 51 and the second portion 52. However, the pad 50 may have the first portion 51 and the second portion 52 as in the first embodiment.

In the second embodiment, the first board 30 has a test pad 95 electrically connected to the pad 50. The test pad 95 is electrically connected to the pad 50 via one or more of a via, a through hole, or the conductive layer 30c provided inside the first board 30. The test pad 95 is exposed on a surface of the first board 30 (for example, the first surface 31a, the second surface 31b, or the first surface 32a).

In the second embodiment, a connection state between the first board 30 and the second board 40 can be inspected by checking electrical continuity between the land 60 and the test pad 95. For example, the electrical continuity between the land 60 and the test pad 95 is checked by bringing the first terminal 91 of the inspection device 90 into contact with the land 60 and bringing the second terminal 92 of the inspection device 90 into contact with the test pad 95.

In this case, when electrical continuity is obtained between the land 60 and the test pad 95, it can be understood that a sufficient amount of solder has been properly supplied. In this case, it can be determined that the connection state between the first board 30 and the second board 40 is satisfactory. On the other hand, if electrical continuity is not obtained between the land 60 and the test pad 95, it can be understood that the amount of solder is insufficient. In this case, it can be determined that the connection state between the first board 30 and the second board 40 is poor.

### (Third embodiment)

Next, a third embodiment will be described. Furthermore, configurations of the third embodiment other than those described below are the same as the configurations of the first embodiment.

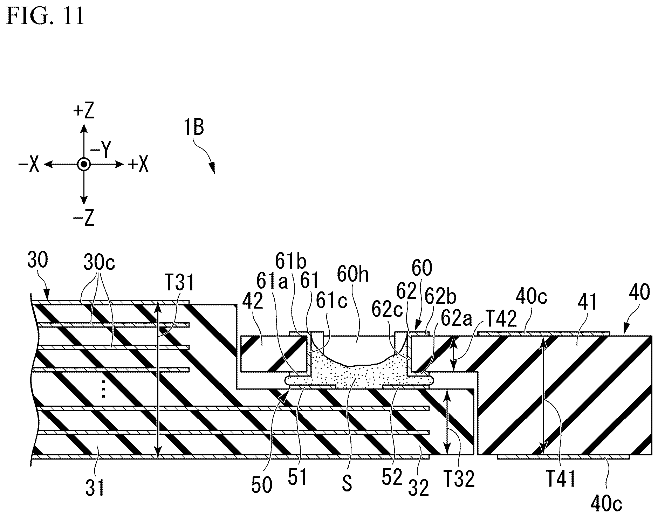

FIG. 11 is a cross-sectional view showing a part of a semiconductor storage device 1B of the third embodiment. In the third embodiment, the fourth portion 42 of the second board 40 is thinner than that in the first embodiment. For example, the thickness T42 of the fourth portion 42 of the second board 40 in the Z direction is smaller than half the thickness T41 of the third portion 41 of the second board 40 in the Z direction. For example, the thickness T42 of the fourth portion 42 of the second board 40 in the Z direction is smaller than the thickness T32 of the second portion 32 of the first board 30 in the Z direction. For example, the thickness T42 of the fourth portion 42 of the second board 40 in the Z direction is smaller than half the thickness T31 of the first portion 31 of the first board 30 in the Z direction.

According to such a configuration, since the fourth portion 42 of the second board 40 is thin, it is easy to visually check a state inside the through hole 60h from the surface of the second board 40, and it is easy to check a state of the connection portion between the first board 30 and the second board 40. Therefore, it is possible to further improve manufacturability of the semiconductor storage device 1B.

### (Fourth embodiment)

Next, a semiconductor storage device 1C according to a fourth embodiment will be described. The fourth embodiment is different from the first embodiment in that a thickness of a second board 40 in the Z direction is smaller than a thickness of a first board 30 in the Z direction. Furthermore, configurations other than those described below are the same as the configurations of the first embodiment.

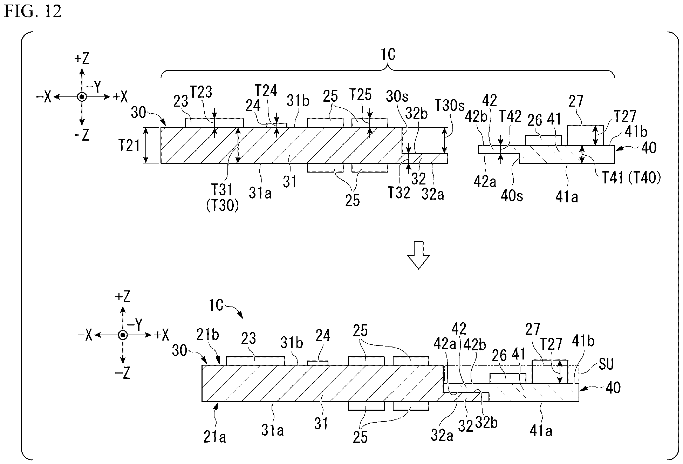

FIG. 12 is a cross-sectional view showing a part of the semiconductor storage device 1C according to the fourth embodiment. In the embodiment, a thickness T40 of the second board 40 in the Z direction is smaller than a thickness T30 of the first board 30 in the Z direction. For example, a thickness T41 of a third portion 41 of the second board 40 in the Z direction is smaller than a thickness T31 of a first portion 31 of the first board 30 in the Z direction.

For example, a thickness T42 of a fourth portion 42 of the second board 40 in the Z direction is smaller than a thickness T30s of a step 30s of the first board 30 in the Z direction. Second surfaces 41b and 42b of the second board 40 are displaced to the side in the -Z direction with respect to a second surface 31b of the first board 30. Therefore, in a region overlapping the second board 40 in the Z direction, a usable space SU is formed due to a difference in height between the second surfaces 41b and 42b of the second board 40 and the second surface 31b of the first board 30.

In the embodiment, for example, a controller 23, a DRAM 24, and a plurality of NANDs 25 are mounted on the second surface 31b of the first board 30. A power supply control component 26 and a plurality of capacitors 27 are mounted on the second surface 41b of the second board 40. At least a part of the power supply control component 26 and each of the capacitors 27 are disposed in the space SU described above. In the embodiment, a thickness T27 of the capacitor 27 in the Z direction is greater than a thickness T23 of the controller 23 in the Z direction, greater than a thickness T24 of the DRAM 24 in the Z direction, and greater than a thickness T25 of the NAND 25 in the Z direction. The capacitor 27 is an example of an electronic component that has a greater thickness than the controller 23, the DRAM 24, and each of the NANDs 25.

According to the configuration described above, the usable space SU is formed due to the difference in height between the second surfaces 41b and 42b of the second board 40 and the second surface 31b of the first board 30. Therefore, even when thick electronic components (for example, the capacitors 27) are mounted on the second board 40, it becomes easier to achieve overall thinning of the semiconductor storage device 1C.

### (Sixth embodiment)

Next, a semiconductor storage device 1D of a sixth embodiment will be described. The sixth embodiment is different from the first embodiment in that a second board 40 is connected in the middle of a first board 30. Furthermore, configurations other than those described below are the same as the configurations of the first embodiment.

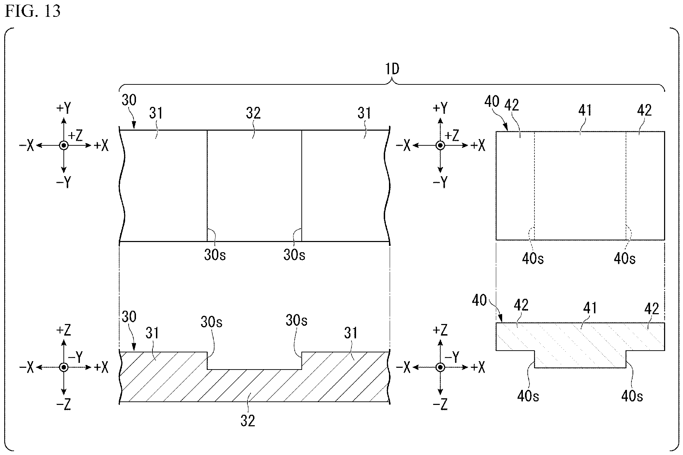

FIG. 13 is a view showing a part of the semiconductor storage device 1D of the sixth embodiment in an exploded manner. In the embodiment, a second portion 32 of the first board 30 is provided midway along the first portion 31 of the first board 30 in the X direction. On the other hand, a fourth portion 42 of the second board 40 is provided on both sides of a third portion 41 of the second board 40 in the X direction.

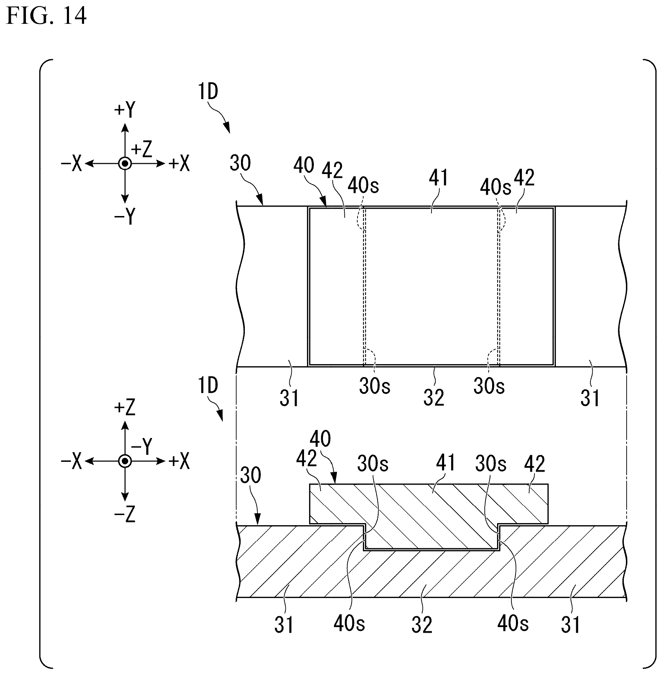

FIG. 14 is a view showing a part of the semiconductor storage device 1D of the sixth embodiment. In the embodiment, the third portion 41 of the second board 40 is disposed to overlap the second portion 32 of the first board 30 when viewed from the Z direction. On the other hand, the fourth portion 42 of the second board 40 is disposed to overlap the first portion 31 of the first board 30 when viewed from the Z direction.

In the embodiment, a first conductive portion (for example, a pad 50) is provided on the first portion 31 of the first board 30, and a second conductive portion (for example, a land 60) is provided on the fourth portion 42 of the second board 40. Alternatively, the first conductive portion (for example, the pad 50) may be provided in the second portion 32 of the first board 30, and the second conductive portion (for example, the land 60) may be provided in the third portion 41 of the second board 40.

According to such a configuration, compared to a board that is not divided into the first board 30 and the second board 40, it is possible to improve a degree of freedom in design, component replacement, or the like. Also, according to the embodiment, a protruding portion formed by the third portion 41 and the fourth portion 42 of the second board 40 is inserted (for example, engaged) into a recessed portion formed by the first portion 31 and the second portion 32 of the first board 30. This allows rough positioning of the second board 40 with respect to the first board 30. Therefore, it is possible to improve manufacturability of the semiconductor storage device 1D.

### (Sixth embodiment)

Next, a semiconductor storage device 1E of a sixth embodiment will be described. The sixth embodiment is different from the first embodiment in that a first board 30 has a two-step difference in level. Furthermore, configurations other than those described below are the same as the configurations of the first embodiment.

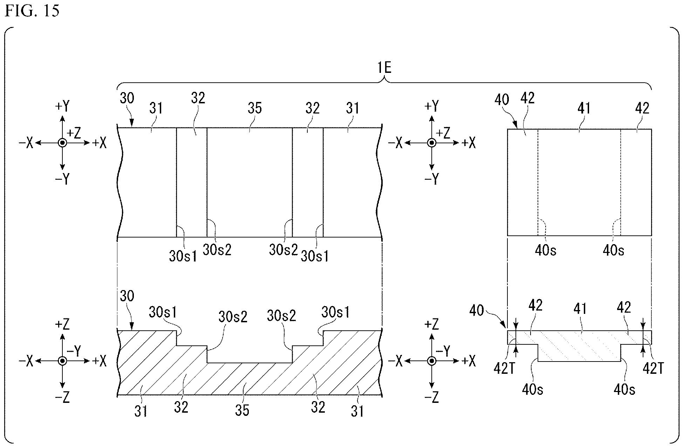

FIG. 15 is a view showing a part of the semiconductor storage device 1E of the sixth embodiment. In the embodiment, the first board 30 includes, for example, a first portion 31, a second portion 32, and a fifth portion 35. The second portion 32 of the first board 30 is provided midway along the first portion 31 of the first board 30 in the X direction. The second portion 32 has a step 30s1 in the Z direction between itself and the first portion 31 and is thinner than the first portion 31. A length of the step 30s1 in the Z direction is greater than, for example, a thickness T42 of a fourth portion 42 of a second board 40 in the Z direction.

The fifth portion 35 of the first board 30 is provided midway along the second portion 32 of the first board 30 in the X direction. The fifth portion 35 has a step 30s2 in the Z direction between itself and the second portion 32, and is thinner than the second portion 32. A length of the step 30s2 in the Z direction is, for example, greater than a length of a step 40s of the second board 40 in the Z direction.

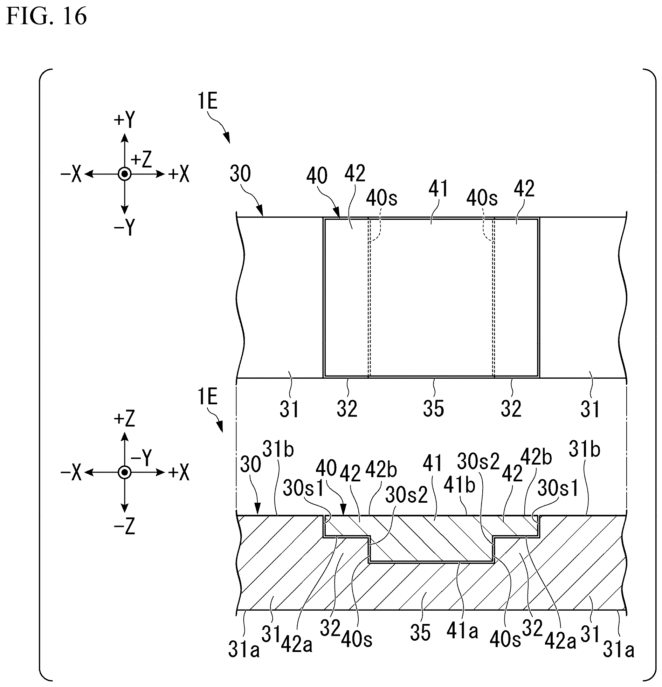

FIG. 16 is a view showing a part of the semiconductor storage device 1E of the sixth embodiment. In the embodiment, a third portion 41 of the second board 40 is disposed to overlap the fifth portion 35 of the first board 30 in the Z direction. On the other hand, the fourth portion 42 of the second board 40 is disposed to overlap the second portion 32 of the first board 30 in the Z direction. In the embodiment, a second surface 31b of the first board 30 and second surfaces 41b and 42b of the second board 40 are positioned on the same plane.

In the embodiment, a first conductive portion (for example, a pad 50) is provided on the second portion 32 of the first board 30, and a second conductive portion (for example, a land 60) is provided on the fourth portion 42 of the second board 40. Alternatively, the first conductive portion (for example, the pad 50) may be provided on the fifth portion 35 of the first board 30, and the second conductive portion (for example, the land 60) may be provided on the third portion 41 of the second board 40.

According to the configuration described above, compared to a board that is not divided into the first board 30 and the second board 40, it is possible to improve a degree of freedom in design, component replacement, or the like. Also, according to the embodiment, when the first portion 31 or the second portion 32 of the first board 30 is used, rough positioning of the second board 40 with respect to the first board 30 can be performed. Therefore, it is possible to improve manufacturability of the semiconductor storage device 1E.

The first embodiment to sixth embodiment have been described above. However, the embodiments are not limited to the above description. For example, the above-described embodiments may be realized in combination with each other. Also, the connection structure between the first board 30 and the second board 40 described in the above embodiments can also be applied to board units used in devices other than semiconductor storage devices.

In the above-described embodiment, an example in which the second portion 32 is provided on the first board 30 and the fourth portion 42 is provided on the second board 40 has been described. Alternatively, the first board 30 may have the first portion 31 and the second portion 32 while the entire second board 40 has the same thickness. Alternatively, the second board 40 may have the third portion 41 and the fourth portion 42 while the entire first board 30 has the same thickness.

In the above-described embodiment, an example in which the controller 23, the DRAM 24, and the NANDs 25 are provided on the first board 30, and the power supply control component 26 and the capacitor 27 are provided on the second board 40 has been described. Alternatively, the controller 23, the DRAM 24, and the NANDs 25 may be provided on the second board 40, and the power supply control components 26 and the capacitor 27 may be provided on the first board 30.

In the above-described embodiment, an example in which the first conductive portion is the pad 50 and the second conductive portion is the land 60 has been described. Alternatively, both the first conductive portion and the second conductive portion may be pads 50 or may be conductive portions having different shapes.

According to at least one of the embodiments described above, the semiconductor storage device includes the first board and the second board. The first board has a first portion, a second portion thinner than the first portion, and a plurality of first conductive portions provided on the second portion. The second board has a plurality of second conductive portions. The plurality of second conductive portions overlap the plurality of first conductive portions when viewed from a first direction which is a thickness direction of the first board. The plurality of second conductive portions are connected to the plurality of first conductive portions by solder in one-to-one correspondence. According to such a configuration, a degree of freedom can be improved.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the inventions. The accompanying claims and their equivalents are intended to cover such forms or modifications as would fall within the scope and the inventions.

A semiconductor storage device according to one embodiment includes a first board and a second board. The first board has a first portion, a second portion thinner than the first portion, and a plurality of first conductive portions on the second portion. The second board has a plurality of second conductive portions. The plurality of second conductive portions overlap the plurality of first conductive portions when viewed from a first direction which is a thickness direction of the first board. The plurality of second conductive portions are connected to the plurality of first conductive portions by solder in one-to-one correspondence.

In the semiconductor storage device, the second board includes a third portion; and a fourth portion. The fourth portion is thinner than the third portion. The fourth portion overlaps the second portion of the first board when viewed from the first direction. The plurality of second conductive portions are in the fourth portion.

In the semiconductor storage device, the second portion is displaced to a first side in the first direction with respect to a center of the first portion in the first direction, the fourth portion is displaced to a second side in the first direction with respect to a center of the third portion in the first direction, and the second side is a side opposite to the first side.

In the semiconductor storage device, the second board is thinner than the first board.

The semiconductor storage device further includes a semiconductor memory, a controller, and a power supply control component. The controller is configured to control the semiconductor memory. The power supply control component is configured to control power supply to the semiconductor memory and the controller. The semiconductor memory and the controller are on one of the first board and the second board. The power supply control component is on the other of the first board and the second board.

The semiconductor storage device further includes: a semiconductor memory, a controller, and a capacitor. The controller is configured to control the semiconductor memory. The capacitor is configured to supply power to the semiconductor memory and the controller. The semiconductor memory and the controller are on one of the first board and the second board. The capacitor is on the other of the first board and the second board.

In the semiconductor storage device, the first board contains a first material, the second board contains a second material, and the first material has at least one of a lower dielectric constant and a lower dielectric loss tangent compared to the second material.

In the semiconductor storage device, each of the plurality of first conductive portions is a pad.

In the semiconductor storage device, the plurality of first conductive portions include a first conductive portion, the plurality of second conductive portions include a second conductive portion, the second conductive portion overlaps the first conductive portion when viewed from the first direction, and the second conductive portion includes a through hole penetrating the second board in the first direction.

In the semiconductor storage device, the through hole is an elongated hole extending in a longitudinal direction thereof in a second direction intersecting the first direction.

In the semiconductor storage device, the through hole includes a first end part and a second end part, the first end part is on one side in the second direction, the second end part is on the other side in the second direction, the second conductive portion includes a first portion and a second portion, the first portion is adjacent to the first end part of the through hole, and the second portion is separated from the first portion and adjacent to the second end part of the through hole.

In the semiconductor storage device, the second portion of the first board is in contact with the fourth portion of the second board.

The semiconductor storage device further includes: a housing and a fastening member. The housing houses the first board and the second board. The housing includes a fixing portion. The fastening member is attached to the fixing portion. The second portion of the first board has a first hole. The second board has a second hole facing the first hole. The fastening member is into the first hole and the second hole to be fixed to the fixing portion.

A board unit according to one embodiment includes a first board and a second board. The first board includes a first portion, a second portion, and a plurality of first conductive portions. The second portion is thinner than the first portion. The plurality of first conductive portions are on the second portion. The second board includes a plurality of second conductive portions. The plurality of second conductive portions overlap the plurality of first conductive portions when viewed from a first direction which is a thickness direction of the first board. The plurality of second conductive portions are connected to the plurality of first conductive portions by solder in one-to-one correspondence.

## Claims

1. A semiconductor storage device (1, 1A, 1B, 1C, 1D, 1E) comprising:
a first board (30) including a first portion (31), a second portion (32), and a plurality of first conductive portions (50), the second portion (32) being thinner than the first portion (31), the plurality of first conductive portions (50) being on the second portion (32); and
a second board (40) including a plurality of second conductive portions (60), wherein
the plurality of second conductive portions (60) overlap the plurality of first conductive portions (50) when viewed from a first direction which is a thickness direction of the first board (30), and
the plurality of second conductive portions (60) are connected to the plurality of first conductive portions (50) by solder in one-to-one correspondence.

2. The semiconductor storage device (1, 1A, 1B, 1C, 1D, 1E) according to claim 1, wherein
the second board (40) includes:
a third portion (41); and
a fourth portion (42) thinner than the third portion (41) and overlapping the second portion (32) of the first board (30) when viewed from the first direction, wherein
the plurality of second conductive portions (60) are in the fourth portion (42).

3. The semiconductor storage device (1, 1A, 1B, 1C, 1D, 1E) according to claim 2, wherein
the second portion (32) is displaced to a first side in the first direction with respect to a center of the first portion (31) in the first direction,
the fourth portion (42) is displaced to a second side in the first direction with respect to a center of the third portion (41) in the first direction, and
the second side is a side opposite to the first side.

4. The semiconductor storage device (1, 1A, 1B, 1C, 1D, 1E) according to claim 3, wherein
the second board (40) is thinner than the first board (30).

5. The semiconductor storage device (1, 1A, 1B, 1C, 1D, 1E) according to any one of claims 1 to 4, further comprising:
a semiconductor memory (25);
a controller (23) configured to control the semiconductor memory (25); and
a power supply control component (26) configured to control power supply to the semiconductor memory (25) and the controller (23), wherein
the semiconductor memory (25) and the controller (23) are on one of the first board (30) and the second board (40), and
the power supply control component (26) is on the other of the first board (30) and the second board (40).

6. The semiconductor storage device (1, 1A, 1B, 1C, 1D, 1E) according to any one of claims 1 to 4, further comprising:
a semiconductor memory (25);
a controller (23) configured to control the semiconductor memory (25); and
a capacitor (27) configured to supply power to the semiconductor memory (25) and the controller (23), wherein
the semiconductor memory (25) and the controller (23) are on one of the first board (30) and the second board (40), and
the capacitor (27) is on the other of the first board (30) and the second board (40).

7. The semiconductor storage device (1, 1A, 1B, 1C, 1D, 1E) according to any one of claims 1 to 4, wherein
the first board (30) contains a first material (M1),
the second board (40) contains a second material (M2), and
the first material (M1) has at least one of a lower dielectric constant and a lower dielectric loss tangent compared to the second material (M2).

8. The semiconductor storage device (1, 1A, 1B, 1C, 1D, 1E) according to any one of claims 1 to 4, wherein
each of the plurality of first conductive portions (50) is a pad.

9. The semiconductor storage device (1, 1A, 1B, 1C, 1D, 1E) according to any one of claims 1 to 4, wherein
the plurality of first conductive portions (50) include a first conductive portion (50),
the plurality of second conductive portions (60) include a second conductive portion (60),
the second conductive portion (60) overlaps the first conductive portion (50) when viewed from the first direction, and
the second conductive portion (60) includes a through hole (60h) penetrating the second board (40) in the first direction.

10. The semiconductor storage device (1, 1A, 1B, 1C, 1D, 1E) according to claim 9, wherein
the through hole (60h) is an elongated hole extending in a longitudinal direction thereof in a second direction intersecting the first direction.

11. The semiconductor storage device (1, 1A, 1B, 1C, 1D, 1E) according to claim 10, wherein
the through hole (60h) includes a first end part (60ha) and a second end part (60hb),
the first end part (60ha) is on one side in the second direction,
the second end part (60hb) is on the other side in the second direction,
the second conductive portion (60) includes a first part (61) and a second part (62),
the first part (61) is adjacent to the first end part (60ha) of the through hole (60h), and
the second part (62) is separated from the first part (61) and adjacent to the second end part (60hb) of the through hole (60h).

12. The semiconductor storage device (1, 1A, 1B, 1C, 1D, 1E) according to any one of claims 2 to 4, wherein
the second portion (32) of the first board (30) is in contact with the fourth portion (42) of the second board (40).

13. The semiconductor storage device (1, 1A, 1B, 1C, 1D, 1E) according to any one of claims 1 to 4, further comprising:
a housing (10) that houses the first board (30) and the second board (40), the housing (10) including a fixing portion (17); and
a fastening member (FS) attached to the fixing portion (17), wherein
the second portion (32) of the first board (30) has a first hole (32h),
the second board (40) has a second hole (42h) facing the first hole (32h); and
the fastening member (FS) is into the first hole (32h) and the second hole (42h) to be fixed to the fixing portion (17).

14. A board unit (20) comprising:
a first board (30) including a first portion (31), a second portion (32), and a plurality of first conductive portions (50), the second portion (32) being thinner than the first portion (31), the plurality of first conductive portions (50) being on the second portion (32); and
a second board (40) including a plurality of second conductive portions (60), wherein
the plurality of second conductive portions (60) overlap the plurality of first conductive portions (50) when viewed from a first direction which is a thickness direction of the first board (30), and
the plurality of second conductive portions (60) are connected to the plurality of first conductive portions (50) by solder in one-to-one correspondence.
